## Europäisches Patentamt

## European Patent Office

## Office européen des brevets

(11) Veröffentlichungsnummer: **0 059 878**

**A1**

(12) # EUROPÄISCHE PATENTANMELDUNG

(21) Anmeldenummer: **82101372.9**

(22) Anmeldetag: **24.02.82**

(51) Int. Cl.³: **G 05 F 3/20**
**H 01 L 27/08**

(30) Priorität: **07.03.81 DE 3108726**

(43) Veröffentlichungstag der Anmeldung:
**15.09.82 Patentblatt 82/37**

(84) Benannte Vertragsstaaten:
**DE FR GB IT NL**

(71) Anmelder: **Deutsche ITT Industries GmbH**
**Hans-Bunte-Strasse 19 Postfach 840**
**D-7800 Freiburg(DE)**

(84) Benannte Vertragsstaaten:
**DE**

(71) Anmelder: **ITT INDUSTRIES, INC.**
**320 Park Avenue**
**New York, NY 10022(US)**

(84) Benannte Vertragsstaaten:
**FR GB IT NL**

(72) Erfinder: **Adam, Fritz Günter Dr.rer.nat. Dipl.-Phys.**
**Furtwänglerstrasse 10**
**D-7800 Freiburg i. Br.(DE)**

(74) Vertreter: **Stutzer, Gerhard, Dr.**
**Deutsche ITT Industries GmbH Patent- und**
**Lizenzabteilung Hans-Bunte-Strasse 19 Postfach 840**
**D-7800 Freiburg(DE)**

(54) **Monolithisch integrierte Referenzspannungsquelle.**

(57) Es wird eine aus einer Source-Drain-Reihenschaltung eines versorgungspotentialseitig liegenden N-Kanal-MOSFETs (T1) des Verarmungstyps mit einem bezugspotentialmäßig liegenden N-Kanal-MOSFET bestehende monolithisch integrierte Referenzspannungsquelle angegeben, welche, bei Einhaltung bestimmter Herstellungsbedingungen hinsichtlich der Gateoxidschichtdicke, der Substratdotierung und des Verhältnisses r der W/L-Verhältnisse (W = Breite und L = Länge des Leitkanals) eine sehr geringe Temperatur-abhängigkeit der Referenzspannung bei geringem Flächenbedarf aufweist. Die Gateelektrode des einen Transistors (T1) liegt am Bezugspotential, während die Referenzspannung (Ur) am Verbindungspunkt (5) der beiden Transistoren (T1, T2) abgegriffen wird.

FIG.1

F. G. Adam 44

Fl 1081 EP
Go/Be
4. Februar 1982

## Monolithisch integrierte Referenzspannungsquelle

Die Erfindung beschäftigt sich mit einer monolithisch integrierten Referenzspannungsquelle, wie sie aus der Zeitschrift "IEEE Journal of Solid-State Circuits" Bd. SC 13, No. 6 (Dez. 1978) Seiten 767 bis 774 und "1978 IEEE International Solid-State Circuits Conference. Digest of Technical Papers" Seiten 178 und 179, bekannt war. Bei dieser Referenzspannungsquelle wird die Erscheinung ausgenutzt, daß die Differenz aus den Schwellenspannungen eines N-Kanal-MOSFETs des Verarmungstyps und eines N-Kanal-MOSFETs des Anreicherungstyps in erster Näherung von der Temperatur unabhängig ist und hauptsächlich von der implantierten Ladung in leicht steuerbarer und reproduzierbarer Weise abhängig ist. Diese Erscheinung wird daher zur Temperaturkompensation in monolithisch integrierten Schaltungen ausgenutzt. Dabei werden die Drainpotentiale der beiden in zwei parallelgeschalteten Zweigen liegenden MOSFETs den beiden Eingängen eines Differenzverstärkers zugeführt. Bei der monolithisch integrierten Referenzspannungsquelle nach der Erfindung wird von diesem Prinzip der Parallelschaltung abgegangen.

Es wurde nämlich festgestellt, daß bei Einhaltung bestimmter Herstellungsbedingungen hinsichtlich der Gateoxidschichtdicke, der Substratdotierung und des Verhältnisses r der W/L-Verhältnisse (W=Breite und L=Länge des Leitkanals) nicht nur eine vergleichsweise sehr gute Temperaturunabhängigkeit der Referenzspannung, sondern bei bestimmten Source-Drain-Reihenschaltungen eines N-Kanal-MOSFETs des Verarmungstyps und eines N-Kanal-MOSFETs des Anreicherungstyps auch eine monolithisch integrierte Referenzspannungsquelle

F.G. Adam 44                                    Fl 1081 EP

mit wenigen MOSFETs und damit geringem Flächenbedarf realisiert werden kann, deren elektrische Eigenschaften in weiten Grenzen von den oben genannten Herstellungsparametern weitgehend unabhängig sind.

Aufgabe der Erfindung ist daher die Angabe einer monolithisch integrierten Referenzspannungsquelle der im Oberbegriff des Anspruchs 1 genannten Art mit möglichst geringer Temperaturabhängigkeit im Bereich von etwa $-20^{\circ}$C und $80^{\circ}$C, deren reproduzierbare Herstellung weitgehend unabhängig von den technologisch bedingten Schwankungen hinsichtlich der Gateoxiddicke, der Substratdotierung und der W/L-Verhältnisse der MOSFETs ist.

Diese Aufgabe wird bei einer monolithisch integrierten Referenzspannungsquelle gemäß dem Oberbegriff des Anspruchs 1 durch die im kennzeichnenden Teil dieses Anspruchs genannte Ausbildung gelöst.

In der monolithisch integrierten Referenzspannungsquelle nach der Erfindung wird also eine besondere Reihenschaltung von Isolierschichtfeldeffekttransistoren mit Gateoxidschichten aus Siliziumoxid (MOSFETs) verwendet, bei der die Gateelektrode  eines ersten MOSFETs mit der Sourceelektrode des zweiten MOSFETs der Reihenschaltung bzw. mit dem Bezugspotential verbunden ist. Umfangreiche Untersuchungen haben ergeben, daß gerade diese Reihenschaltung zur Lösung der oben genannten Aufgabe besonders gut geeignet ist.

Die Erfindung wird im folgenden anhand der Zeichnung er-läuiert,

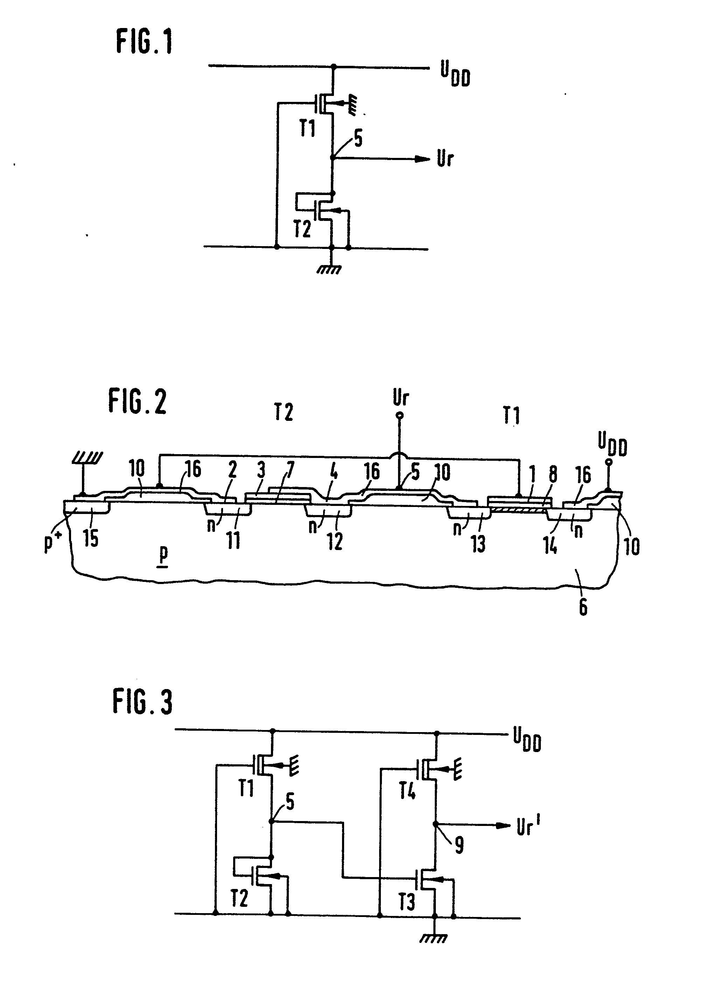

deren Fig. 1 die Grundschaltung der monolithisch integrierten Referenzspannungsquelle nach der Erfindung zeigt,

F.G. Adam 44                          Fl 1081 EP

deren Fig. 2   in Teilschnittsicht die monolithisch
integrierte Referenzspannungsquelle nach
der Erfindung gemäß der Grundschaltung
nach Fig. 1 veranschaulicht und

deren Fig. 3   die Schaltung einer Weiterbildung der
Grundschaltung nach Fig. 1 darstellt.


Die Drain-Source-Reihenschaltung (Fig. 1) eines N-Kanal-MOSFETs T1 des Verarmungstyps, dessen Drainelektrode an der Versorgungsspannung $U_{DD}$ liegt, mit einem N-Kanal-MOSFETs T2 des Anreicherungstyps, dessen Sourceelektrode am Bezugspotential liegt, weist die Besonderheit auf, daß die Gateelektrode des MOSFETs T1 auf das Bezugspotential gelegt ist und die Gateelektrode des MOSFETs T2 mit dem Verbindungspunkt 5 der Drain-Source-Reihenschaltung verbunden ist. Das Substrat der beiden MOSFETs T1 und T2 liegt am Bezugspotential, während die Referenzspannung Ur am gemeinsamen Verbindungspunkt 5 abgegriffen wird.

Die Fig. 2 veranschaulicht ausschnittsweise in üblicher Querschnittsansicht etwa senkrecht zur Oberflächenseite einer Halbleiterplatte die Integration der Referenzspannungsquelle gemäß der Fig. 1, welche in der in der Fachwelt allgemein bekannten Si-Gate-Technologie realisiert wird. Dabei werden die zur Herstellung der beiden MOSFETs T1 und T2 erforderlichen Oberflächenbereiche des mit der Dickoxidschicht 10 bedeckten Si-Substrats 6 freigelegt. Die Akzeptorenkonzentration des Substrats 6 ist zwischen $5 \cdot 10^{14} \mathrm{cm}^{-3}$ bis $7 \cdot 10^{14} \mathrm{cm}^{-3}$ zu wählen.

Danach wird die die Dickoxidschicht 10 aufweisende Oberflächenseite mit einer gegen eine Ionenimplantation maskierenden Schicht, vorzugsweise aus einem Photolack, bedeckt

F.G. Adam 44                                           Fl 1081 EP

und in dieser in der Figur nicht dargestellten Photolackmaskierungsschicht ein Durchbruch an der Stelle der noch herzustellenden Si-Gateelektrode des MOSFETs T1 hergestellt. Die maskierte Oberflächenseite wird nun einem Implantationsprozess von Donatoren solange ausgesetzt, bis $0,75 \cdot 10^{12} cm^{-2}$ bis $1,25 \cdot 10^{12} cm^{-2}$ in die freigelegte Halbleiteroberfläche des MOSFETs T1 implantiert sind.

Nach Entfernung der gegen Ionen maskierenden Schicht wird die freigelegte Halbleiteroberfläche innerhalb der Durchbrüche der Dickoxidschicht 10 mit einer Oxidschicht ausgefüllt, die zwischen 0,060 und 0,066 µm zu bemessen ist. Entsprechend der Si-Gate-Technologie wird nun eine polykristalline Si-Schicht aus der Gasphase aufgebracht, welche mit Donatoren in einer Konzentration von etwa $10^{20} cm^{-3}$ dotiert werden kann.

Anschließend werden die Gateelektroden 1 und 3 mit ihren angrenzenden Gateoxidschichten 7 und 8 unter Anwendung eines photolithographischen Ätzprozesses und unter Freilegung der Halbleiteroberfläche in den Bereichen der zu diffundierenden Zonen 11 und 14 freigelegt und ein n-dotierender Planardiffusionsprozess durchgeführt, wobei die Gateelektroden 1 und 3 mit ihren angrenzenden Gateoxidschichten 7 und 8 als Diffusionsmaske wirken.

Unter Anwendung eines besonderen p-dotierenden Planardiffusionsprozesses kann die Kontaktierungszone 15 hergestellt werden, an der das Bezugspotential des Substrats 6 liegt und mit der die Gateelektrode 1 des MOSFETs T1 zu verbinden ist, wie die Fig. 2 veranschaulicht. Dazu und zur Herstellung der weiteren in der Fig. 1 gezeigten Verbindungen werden Leitbahnen 16 aufgebracht, von denen eine beispielsweise die Sourceelektrode des MOSFETs T2 mit dem Substrat 6 kontaktiert.

F.G. Adam 44                                    . Fl 1081 EP

Zur Lösung der der Erfindung zugrundeliegende Aufgabe ist ferner ein besonderes Verhältnis $r_{12}$ der W/L-Verhältnisse der beiden MOSFETs T1 und T2 zu beachten. Dieses Verhältnis $r_{12}$ soll zwischen 1,10 und 1,40 liegen.

Bei der Herstellung von integrierten Referenzspannungsquellen nach der Erfindung ist natürlich eine gewisse Schwankung der r-Werte nicht zu vermeiden, die sich auf gewisse, wenn auch geringe, Schwankungen der Referenzspannung Ur auswirkt.

Die Fig. 3 zeigt die Schaltung einer Weiterbildung der monolithisch integrierten Referenzspannungsquelle nach der Erfindung. Im Prinzip ist die Schaltung gemäß der Fig. 3, eine Hintereinanderschaltung von zwei Referenzspannungsquellen gemäß der Fig. 1, wobei die Referenzspannung Ur der ersten die MOSFETs T1 und T2 enthaltenden Referenzquelle an die Gateelektrode eines dritten N-Kanal-MOSFETs T3 des Anreicherungstyps einer weiteren Drain-Source-Reihenschaltung dieses MOSFETs T3 mit einem vierten versorgungsspannungsseitig liegenden N-Kanal-MOSFET T4 des Verarmungstyps angelegt ist. Die Gateelektrode dieses zuletzt genannten MOSFETs T4 ist in gleicher Weise wie die des MOSFETs T1 der ersten Reihenschaltung T1 und T2 mit dem Bezugspotential verbunden. Natürlich fehlt eine entsprechende Verbindung der Gateelektrode des dritten bezugspotentialseitig liegenden MOSFETs T3 des Anreicherungstyps mit dem Verbindungspunkt 9 der Reihenschaltung, von welchem eine weitere Referenzspannung Ur' abgegriffen wird.

Die Referenzspannungsquelle gemäß der Fig. 3 kann in gleicher Weise wie die der Fig. 1 unter Verwendung der allgemein bekannten Si-Gate-Technologie realisiert werden. In beiden Fällen kommt aber auch eine Realisierung in der bekannten Al-Technologie in Frage, bei der Gateelektroden aus Aluminium verwendet werden.

F.G. Adam 44                    Fl 1081 EP
                                Go/Be
                                4. Februar 1982

Patentanspruch

Monolithisch integrierte Referenzspannungsquelle
mit einer zwischen einem Versorgungspotential($U_{DD}$)
und einem Bezugspotential liegenden Drain-Source-Reihenschaltung eines versorgungspotentialseitig liegenden
N-Kanal-MOSFETs (T1) des Verarmungstyps und eines
bezugspotentialseitig liegenden N-Kanal-MOSFETs (T2)
des Anreicherungstyps, dadurch gekennzeichnet,

- daß die Gateelektrode (1) des ersten MOSFETs
  (T1) mit der am Bezugspotential liegenden
  Sourceelektrode (2) des zweiten MOSFETs (T2)
  verbunden ist, dessen Gateelektrode (3) mit
  seiner am Verbindungspunkt (5) der beiden
  MOSFETs (T1, T2) liegenden Drainelektrode (4)
  verbunden ist,

- daß die Referenzspannung (Ur) am Verbindungspunkt (5) der beiden MOSFETs (T1,
  T2) abgegriffen wird,

- daß die Gateoxidschichtdicke der beiden
  MOSFETs (T1, T2) zwischen 0,060 und 0,066 $\mu$m
  bemessen ist,

- daß die Substratdotierung des p-dotierten
  Substrats (6) unter dem Gateoxid (7) des zweiten
  MOSFETs (T2) zwischen (5 und 7). $10^{14} cm^{-3}$
  gewählt ist und in die Substratoberfläche
  unter dem Gateoxid (8) des ersten MOSFETs (T1)
  0,75 . $10^{12} cm^{-2}$ bis 1.25 $10^{12} cm^{-2}$ Donatoren
  implantiert sind und

F.G. Adam 44                                    Fl 1081 EP

- daß das Verhältnis $r_{12} = \dfrac{(W/L)_1}{(W/L)_2}$ der beiden

  MOSFETs (T1, T2) zwischen 1,1 bis 1,4 liegt,
  wobei jeweils W die Breite und L die Länge des
  Leitkanals der betroffenen MOSFETs (T1, T2) ist.

**FIG.1**

**FIG.2**

**FIG.3**

# EUROPÄISCHER RECHERCHENBERICHT

**0059878**

Nummer der Anmeldung

EP 82 10 1372

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. 3) |
|---|---|---|---|
| X | US-A-4 031 456 (HITACHI) * Spalte 1, Zeile 1 - Spalte 4, Zeile 26; Figuren 1,2,4 * | 1 | G 05 F 3/20 H 01 L 27/08 |
| | --- | | |
| A | FR-A-2 441 885 (PHILIPS) * Seite 13, Zeilen 5-23; Figur 5 * & DE - A - 2945463 | 1 | |
| | --- | | |
| A | IBM TECHNICAL DISCLOSURE BULLETIN, Band 13, Nr. 9, Februar 1971, Seite 2516, New York, USA U.G. BAITINGER et al.: "Constant-current source network" * Insgesamt * | 1 | |
| | --- | | |
| A | IBM TECHNICAL DISCLOSURE BULLETIN, Band 22, Nr. 11, April 1980, Seiten 5152,5153, New York, USA H.H. CHAO et al.: "Fabrication procedure for MOSFET logic integrated circuit with very thin gate oxide" * Insgesamt * | 1 | **RECHERCHIERTE SACHGEBIETE (Int. Cl. 3)** G 05 F 3/00 H 01 L 27/00 |
| | ----- | | |

Der vorliegende Recherchenbericht wurde für alle Patentansprüche erstellt.

| Recherchenort | Abschlußdatum der Recherche | Prüfer |
|---|---|---|
| DEN HAAG | 18-05-1982 | ZAEGEL B.C. |